# EUROPEAN PATENT APPLICATION

(11) **EP 4 560 708 A1**
(43) Date of publication of application: **28.05.2025**
(21) Application number: 23842963.3
(22) Date of filing: 18.07.2023
(51) Int. Cl.: H01L 31/042, H01L 31/05

(54) **PHOTOVOLTAIC MODULE**

(30) Priority: 21.07.2022 JP 2022116671
(71) Applicant: Sharp Kabushiki Kaisha, Sakai City, Osaka 590-8522 (JP)
(72) Inventor: OKAMOTO, Chikao, Sakai City, Osaka 590-8522 (JP)
(74) Representative: Müller Hoffmann & Partner
(86) International application number: PCT/JP2023/026243
(87) International publication number: WO 2024/019040

(57) **Abstract**

A solar cell module includes: a plurality of solar cells arranged in a first direction and in a second direction; and connection members electrically connecting the plurality of solar cells. The connection members include: a first wiring member that connects one solar cell and another solar cell arranged adjacent to each other in the first direction; and a second wiring member that connects one solar cell and another solar cell arranged adjacent to each other in the second direction. The second wiring member is provided on a back surface side opposite to a light-receiving surface side of the solar cell so as to intersect the first wiring member and also to be electrically connected to the first wiring member. The plurality of solar cells is connected in series by the first wiring member and is connected in parallel by the second wiring member.

## Description

### Technical Field

The present disclosure relates to solar cell modules.

### Background Art

Conventionally, a configuration of a solar cell module is known, in which a plurality of solar cells each having a substantially rectangular shape is located between a transparent substrate and a protection member so as to be arranged in a matrix in a frame body. In this type of solar cell module, each of the plurality of solar cells in the matrix is connected in series to constitute a cell group, and this cell group is further connected to another cell group in series to constitute a solar cell string, and then, a plurality of solar cell strings is connected in parallel.

Also, a technology is known, in which a plurality of solar cells is disposed on a wiring sheet made of an insulating base material. One surface of the wiring sheet is provided with wiring members so as to connect electrodes of the solar cells, and the solar cells and wiring sheet are fixed by an adhesive such as a resin. For example, in Patent Document 1, a solar cell module is disclosed, in which solar cells and a wiring sheet are fixed by an adhesive so that a plurality of solar cells is electrically connected in series.

### Prior Art Document

### Patent Document

Patent Document 1: JP 2009-088145 A

### Summary of the Invention

### Problem to Be Solved by the Invention

In the above-described conventional solar cell module, if a building or the like casts a shadow over some solar cells or if foreign substances adhere to surfaces of the solar cells, among the plurality of solar cells, these solar cells cannot receive sunlight. Even though the solar cell module has a bypass diode, the current does not flow through the bypass diode depending on the light-shielding rate of the solar cells, which results in no formation of the bypass path to bypass the shaded solar cells. In such a case, the shaded solar cell is in the reverse-bias condition, which causes local heat called a "hotspot" phenomenon. As a result, the solar cells and/or other components of the solar cell module are often damaged.

The present disclosure was made in consideration of the above circumstances, an object of which is to provide a solar cell module capable of reducing generation of a hotspot phenomenon and stabilizing a power generation amount.

### Means for Solving the Problem

As means for achieving the object of the present disclosure, a solar cell module of the present disclosure includes: a plurality of solar cells arranged in a first direction and in a second direction orthogonal to the first direction; and connection members electrically connecting the plurality of solar cells. The connection members include: a first wiring member that connects, in the plurality of solar cells, one solar cell and another solar cell arranged adjacent to each other in the first direction; and a second wiring member that connects, in the plurality of solar cells, one solar cell and another solar cell arranged adjacent to each other in the second direction. The second wiring member is provided on a light-receiving surface side of the solar cells or a back surface side opposite to the light-receiving surface side so as to intersect the first wiring member and also to be electrically connected to the first wiring member. The plurality of solar cells is connected in series by the first wiring member and is connected in parallel by the second wiring member.

In the solar cell module as described above, it is preferable that the first wiring member is connected to a front surface electrode of the one solar cell and to a back surface electrode of the other solar cell arranged adjacent to the one solar cell in the first direction. Also it is preferable that the second wiring member is connected to the first wiring member that is connected to the back surface electrode.

In this case, it is preferable that the second wiring member is connected to the first wiring member by welding or via a conductive adhesive.

Also in the solar cell module as described above, the second wiring member may be connected to a back surface electrode of the one solar cell and to a back surface electrode of the other solar cell arranged adjacent to the one solar cell in the second direction. Also, the first wiring member may be connected to the front surface electrode of the one solar cell and to the second wiring member that is connected to the back surface electrode of the other solar cell arranged adjacent to the one solar cell in the first direction.

In this case, it is preferable that the second wiring member is connected to the back surface electrode of the solar cell by welding or via a conductive adhesive, and that the first wiring member is connected to the second wiring member by welding or via a conductive adhesive.

Also in the solar cell module as described above, the first wiring member may be connected to the front surface electrode of the one solar cell and to the back surface electrode of the other solar cell arranged adjacent to the one solar cell in the first direction. Also, the second wiring member may be connected to the first wiring member that is connected to the front surface electrode.

In this case, it is preferable that the second wiring member is connected to the first wiring member by welding or via a conductive adhesive.

Also in the solar cell module as described above, the second wiring member may be connected to a front surface electrode of the one solar cell and to a front surface electrode of the other solar cell arranged adjacent to the one solar cell in the second direction. Also, the first wiring member may be connected to the second wiring member that is connected to the front surface electrode of the one solar cell and to the back surface electrode of the other solar cell arranged adjacent to the one solar cell in the first direction.

In this case, it is preferable that the second wiring member is connected to the front surface electrode of the solar cell by welding or via a conductive adhesive, and that the first wiring member is connected to the second wiring member by welding or via a conductive adhesive.

Also in the solar cell module as described above, it is preferable that the second wiring member is a metal foil. Furthermore in the solar cell module as described above, the second wiring member may be a wire-shaped conductive member, or may be a strip-shaped conductive member.

Also in the solar cell module as described above, the first wiring member and the second wiring member may constitute a mesh-shaped conductive member by being intersected with and connected to each other.

### Effects of the Invention

With the solar cell module of the present disclosure, it is possible to stabilize the power generation amount even when some solar cells are in the reverse bias condition caused by light-shielding or the like.

### Brief Description of the Drawings

[FIG. 1]

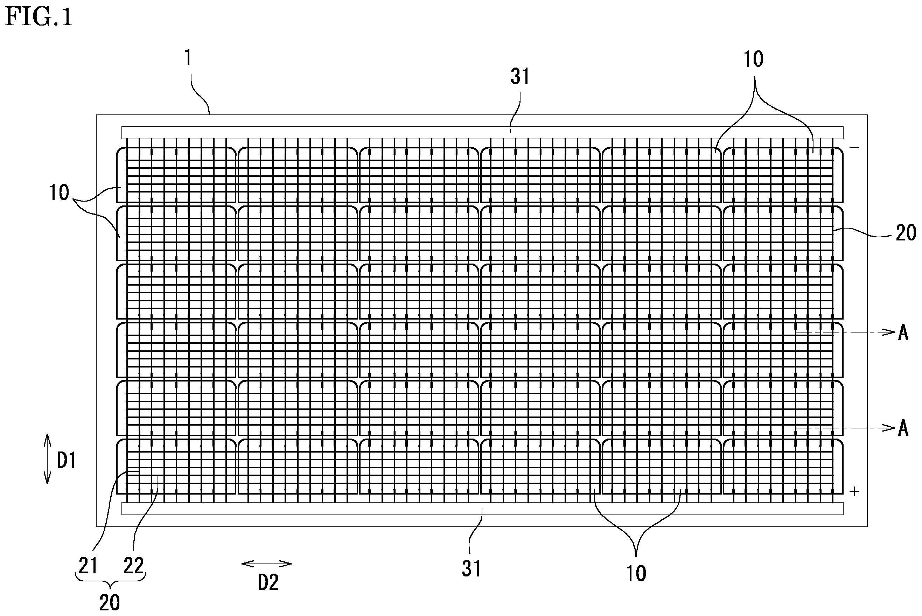

   FIG. 1 is a plan view illustrating a solar cell module according to Embodiment 1 of the present disclosure.
[FIG. 2]

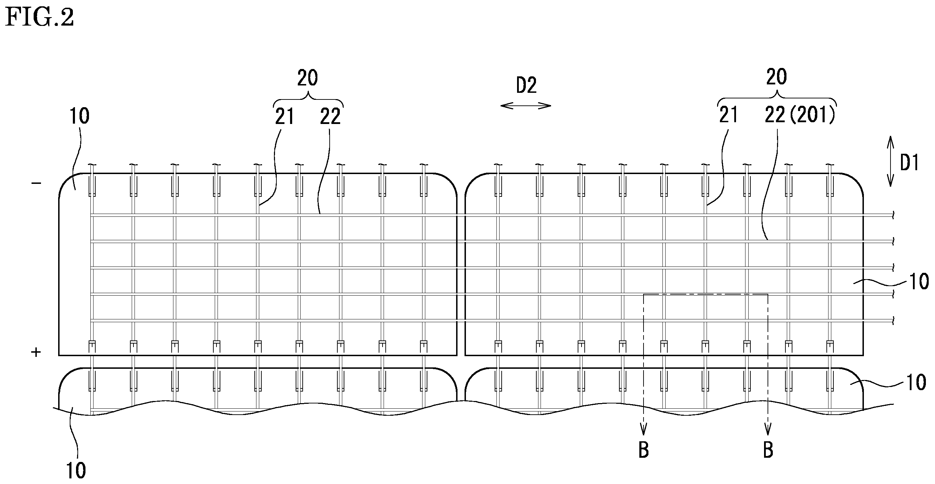

   FIG. 2 is an enlarged plan view illustrating a part of the solar cell module shown in FIG. 1.
[FIG. 3]

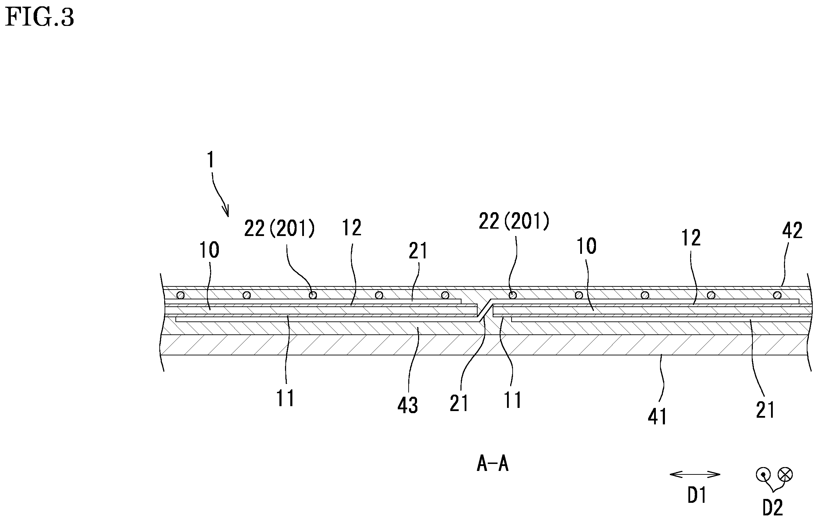

   FIG. 3 is a cross-sectional view of the solar cell module, which is taken from line A-A of FIG. 1.
[FIG. 4]

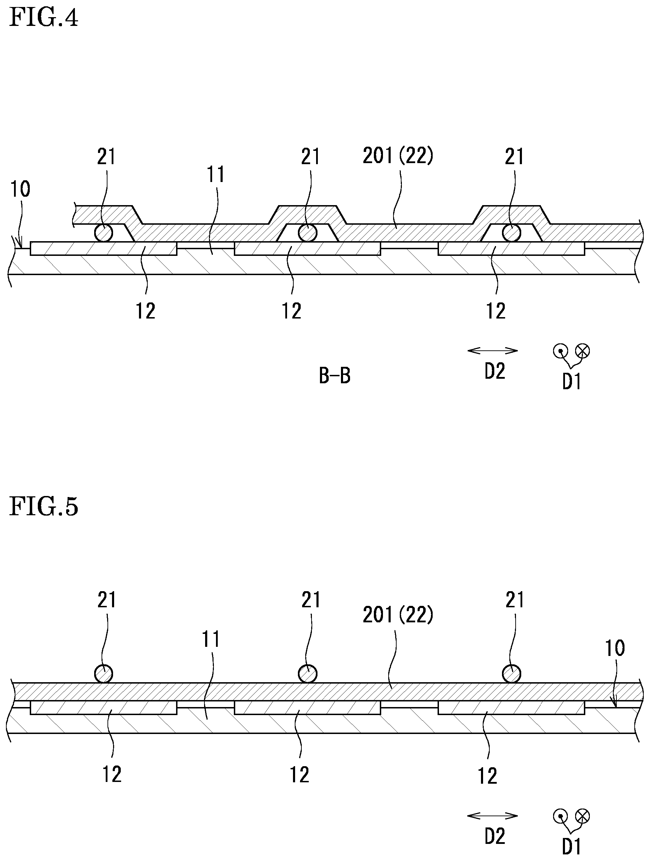

   FIG. 4 is a cross-sectional view schematically illustrating a configuration of a back surface of a solar cell in the solar cell module, which is taken from line B-B of FIG. 2.
[FIG. 5]
   FIG. 5 is a cross-sectional view schematically illustrating a configuration of the back surface of the solar cell in the solar cell module according to Embodiment 2 of the present disclosure.
[FIG. 6]

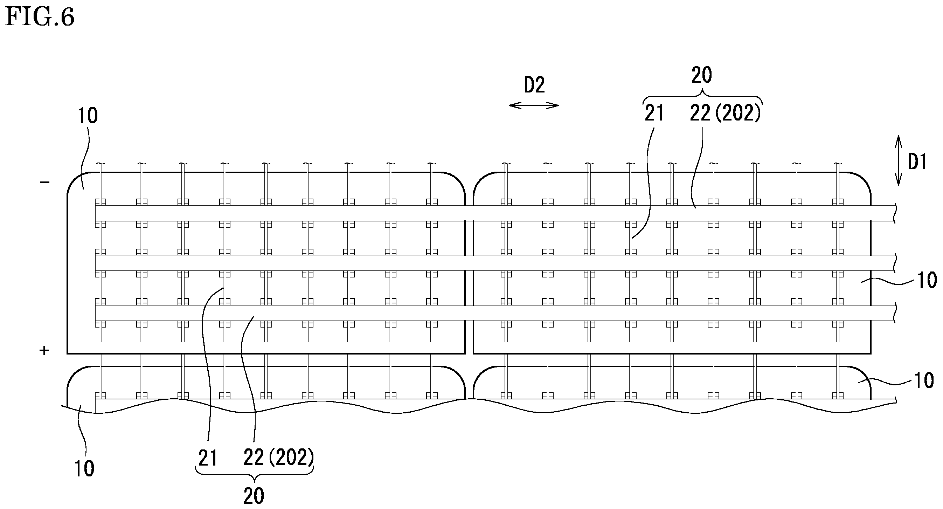

   FIG. 6 is an enlarged plan view illustrating a part of the solar cell module according to Embodiment 3 of the present disclosure.
[FIG. 7]

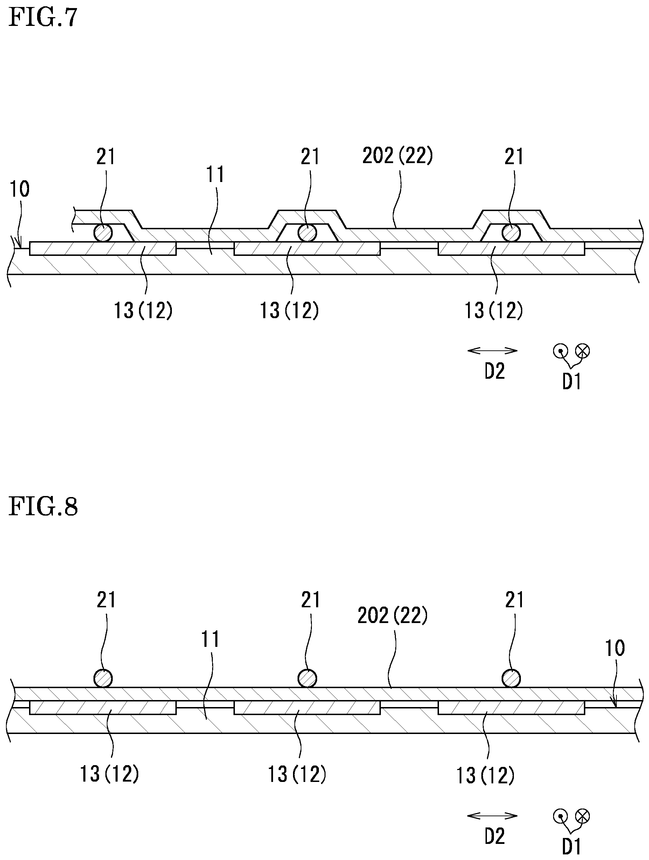

   FIG. 7 is a cross-sectional view schematically illustrating a configuration of the back surface of the solar cell in the solar cell module.
[FIG. 8]
   FIG. 8 is a cross-sectional view schematically illustrating another configuration of the back surface of the solar cell in the solar cell module.
[FIG. 9]

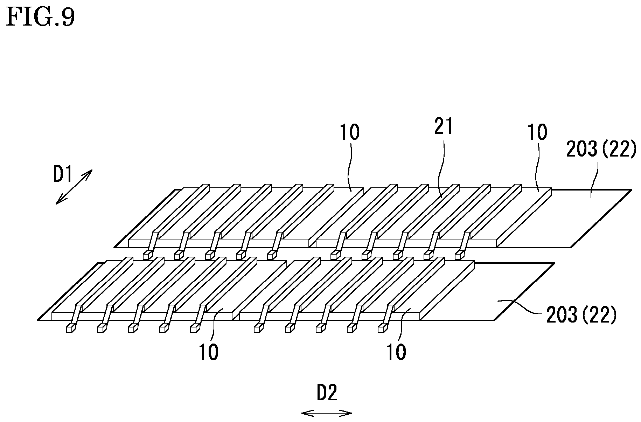

   FIG. 9 is a perspective view schematically illustrating a connection structure of a first wiring member and a second wiring member in the solar cell module according to Embodiment 4 of the present disclosure.
[FIG. 10]

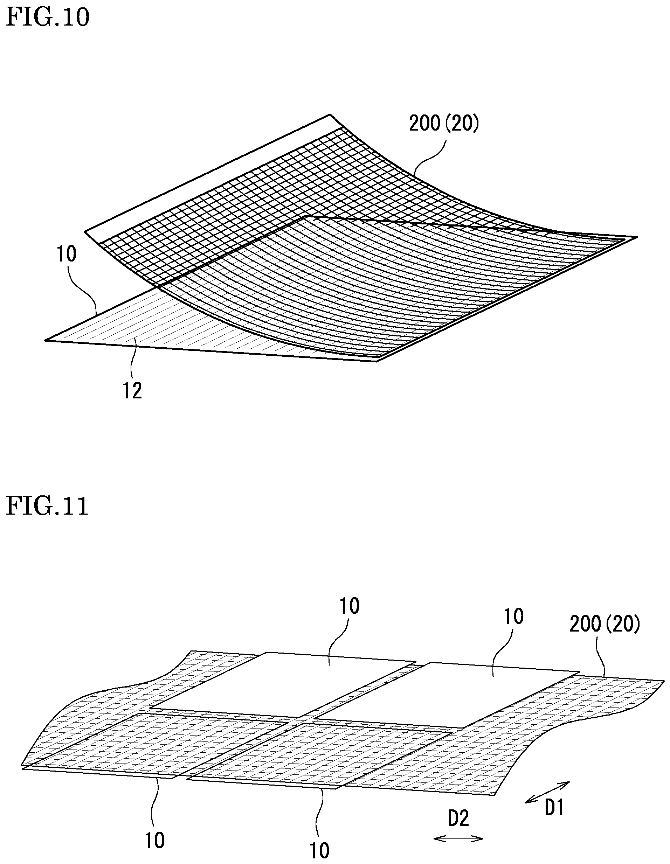

   FIG. 10 is a perspective view illustrating connection members in the solar cell module according to Embodiment 5 of the present disclosure.
[FIG. 11]
   FIG. 11 is a perspective view schematically illustrating a connection structure of the solar cells in the solar cell module.
[FIG. 12A]

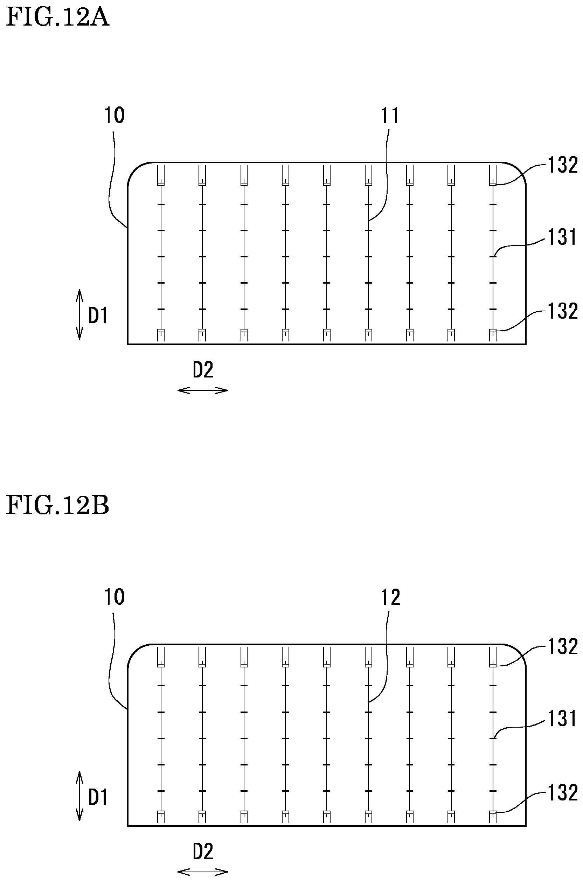

   FIG. 12A is an explanatory diagram illustrating a light receiving surface of the solar cell as an example.
[FIG. 12B]
   FIG. 12B is an explanatory diagram illustrating the back surface of the solar cell.
[FIG. 13A]

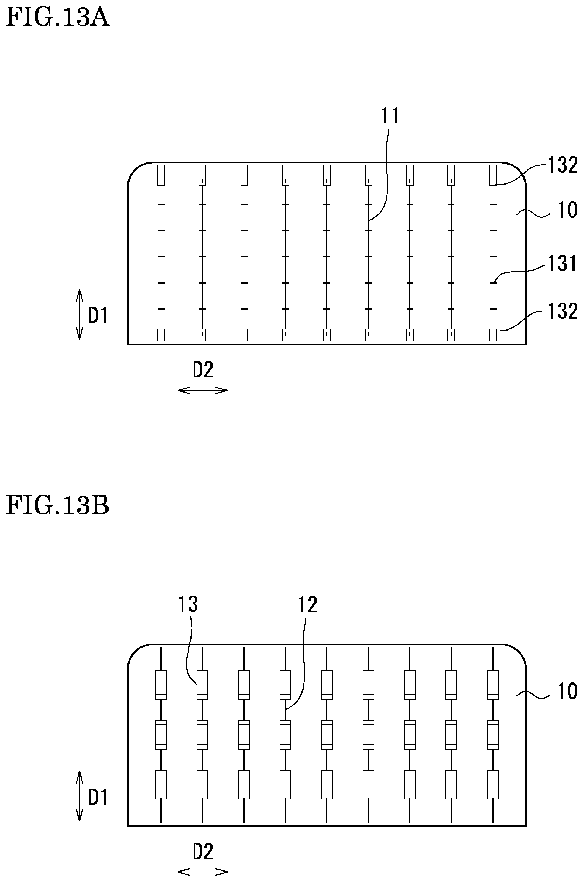

   FIG. 13A is an explanatory diagram illustrating the light-receiving surface of the solar cell as another example.
[FIG. 13B]
   FIG. 13B is an explanatory diagram illustrating the back surface of the solar cell.
[FIG. 14]

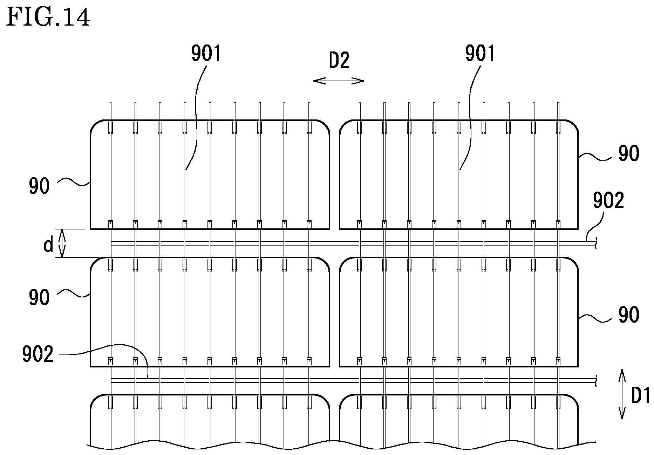

   FIG. 14 is a plan view illustrating a connection structure of the solar cells in the solar cell module as a comparative example.

### Modes for Carrying Out the Invention

Hereinafter, a solar cell module according to embodiments of the present disclosure will be described with reference to the drawings.

### <Embodiment 1>

FIG. 1 is a plan view illustrating a configuration of a solar cell module 1 according to Embodiment 1. FIG. 2 is an enlarged plan view illustrating a part of the solar cell module 1 shown in FIG. 1. FIGS. 1 and 2 both show the solar cell module 1 viewed from the back surface side thereof, which is opposite to the light-receiving surface. Also, the illustration of a resin layer, a protection member and the like provided in the solar cell module 1 is omitted here.

As shown in FIG. 1, the solar cell module 1 includes a plurality of solar cells 10 arranged to be separated from each other, and a plurality of connection members 20 electrically connecting the plurality of solar cells 10.

The plurality of solar cells 10 is arranged in a matrix in a first direction D1 and in a second direction D2 orthogonal to the first direction D1. The solar cells 10 each have a flat plate shape. In the example shown in FIG. 1, a split cell made by dividing a solar cell substrate having a size of about 156 mm square into two equal cells. Therefore, the solar cell 10 has a size of about 156 mm × 78 mm.

Here, a split cell is a small cell made by splitting a standard sized solar cell (a cell corresponding to one solar cell wafer, also called a "full cell"). Examples of the split cells include cells made by dividing the standard sized cell in half (half cells). Using the split cells can decrease the current value per solar cell (decrease in half in case of the half cell), which leads to decrease in power loss of the solar cell module 1. Furthermore, since the number of the split cells that can be connected in series is larger than the number of the standard sized solar cells, a high voltage can be obtained. In the aspect exemplarily shown, the solar cells 10 are the half cells. In this aspect, although the half cells are used as the solar cells 10, which are made by dividing the standard sized cell into two equal cells, it is also possible to use the split cells made by dividing the standard sized cell into three (size of one-third) or made by dividing it into four (size of one-fourth). Also, the shape of the split cell may be a substantially square shape by further dividing the half cell in half.

As shown in FIG. 2, as the connection members 20 for the plurality of solar cells 10 adjacent to one another, first wiring members 21 each extending in the first direction D1 and second wiring members 22 each extending in the second direction D2 are provided. The first wiring member 21 connects, in series, one solar cell 10 and another solar cell 10 arranged adjacent to each other in the first direction D1. The second wiring member 22 connects, in parallel, one solar cell 10 and another solar cell 10 arranged adjacent to each other in the second direction D2.

FIG. 3 is a cross-sectional view of the solar cell module 1, which is taken from line A-A of FIG. 1. FIG. 4 is a cross-sectional view schematically illustrating a configuration of the back surface of the solar cell 10, which is taken from line B-B of FIG. 2. FIG. 4 shows the enlarged configuration of the back surface of the solar cell 10, from which the components of the solar cell 10 such as a resin layer 43, a protection member 42 of the back surface, and a front surface electrode 11 of the light-receiving surface are omitted.

As shown in FIG. 3, the solar cell module 1 has a configuration in which the solar cells 10 and the like are disposed between a transparent substrate 41 and the protection member 42, and sealed by the transparent resin layer 43. The transparent substrate 41 is disposed so as to face a light-receiving surface (i.e. the front surface, provided on the lower side in FIG. 3) of the solar cell 10. The protection member 42 is disposed so as to face the back surface of the solar cell 10 (i.e. provided on the upper side in FIG. 3). Here, the "light-receiving surface" of the solar cell module 1 means a surface where the sunlight mainly enters, and the "back surface" means a surface opposite to the light-receiving surface.

FIGS. 12A and 12B show one example of the solar cell 10. FIG. 12A is a plan view illustrating the light-receiving surface of the solar cell 10, while FIG. 12B is a plan view illustrating the back surface of the solar cell 10.

The solar cell 10 is a flat photovoltaic element that generates electric power by receiving light irradiation, and includes a front surface electrode 11 and a back surface electrode 12. As shown in FIG. 12A as an example, the front surface electrode 11 is provided on the light-receiving surface of the solar cell 10 and includes, for example, a busbar electrode and a finger electrode (not shown). The busbar electrode of the front surface electrode 11 is formed on the light-receiving surface of the solar cell 10 so as to linearly extend in the first direction D1. The finger electrode is formed so as to linearly extend in the second direction D2 from the busbar electrode.

As shown in FIG. 12B, the back surface electrode 12 is provided on the back surface side so as to be opposite to the front surface electrode 11 on the front surface side. The back electrode 12 is provided on the back surface of the solar cell 10 so as to linearly extend in the first direction D1. Also, as shown in FIG. 4, the back surface electrode 12 is a strip-shaped member provided on the back surface of the solar cell 10 (i.e. provided on the upper side in FIG. 4) so as to linearly extend in the first direction D1.

On the busbar electrode (collector electrode), a plurality of pads 131 is provided so as to enhance adhesion to a wiring member such as a wire, and thus to make a connection with less contact resistance. The end parts of the solar cell 10 in the first direction D1 are also provided with end pads 132. These pads 131 and the end pads 132 each have a relatively large width, and serve as a region to which the second wiring member 22 (described later) or the like is adhered and fixed.

The first wiring member 21 is a wire-shaped (or linear) conductive member. More specifically, the first wiring member 21 is a wire-shaped wiring member (inter-connector wire) having a configuration in which an outer surface of a wire having a substantially circular cross section is coated with a conductive adhesive or a solder. The material of the wire is not particularly limited, however, a metal such as copper may be used.

As shown in FIG. 3, the first wiring member 21 connects the front surface electrode 11 of one solar cell 10 and the back surface electrode 12 of another solar cell 10, which are arranged in the first direction D1. The first wiring member 21 is connected to the back surface electrode 12 of the solar cell 10 by welding or via a conductive adhesive. In this way, the solar cells 10 and 10 that are arranged adjacent to each other in the first direction D1 are electrically connected in series by the first wiring member 21 provided along the first direction D1.

The first wiring member 21 is electrically connected to a busbar 31 at the end part in the first direction D1 so as to extract electric power from a plurality of solar cells 10 (solar cell string) in the first direction D1.

Referring to FIG. 2 again, a plurality of solar cells 10 arranged side by side in the second direction D2 are connected by the second wiring member 22 extending along the second direction D2. As shown in FIG. 3, the second wiring member 22 is also a wire-shaped (or linear) conductive member that is the same as the first wiring member 21. More specifically, the second wiring member 22 is a wire-shaped conductive member (inter-connector wire) 201 having a configuration in which an outer surface of a conductive wire having a substantially circular cross section is coated with a conductive adhesive or a solder.

At least part of the conductive member 201 as the second wiring member 22 preferably has a cross-sectional shape of a circle or an ellipse. As an example, the diameter of the conductive member 201 is in a range of about 0.30 to 0.35 mm. The material of the wire of the conductive member 201 is not particularly limited, however, a metal such as copper may be used.

As shown in FIG. 4, the second wiring member 22 is provided on the back surface of the solar cell 10 so as to: intersect the first wiring member 21 that is connected to the back surface electrode 12; and be connected to the first wiring member 21. Also, the second wiring member 22 is electrically connected to the first wiring member 21 by welding or via a conductive adhesive. In this way, the solar cells 10 that are arranged side by side in the second direction D2 are electrically connected in parallel by the second wiring member 22.

The welding of the first wiring member 21 and the back surface electrode 12, as well as the welding of the first wiring member 21 and the second wiring member 22 can be performed by bonding (welding and fixing) using an ultrasonic welding method, a laser welding method or the like. Also, as the above-described conductive adhesive, a solder, a conductive solder resin, or a conductive paste may be used. Among the above, the solder is particularly preferable.

In this way, in the solar cell module 1, 6 solar cells 10 are arranged in the first direction D1 and electrically connected in series by the connection members 20 (the first wiring members 21). Also, 6 solar cells 10 are arranged side by side in the second direction D2 and electrically connected in parallel by the connection members 20 (the second wiring members 22). That is, the solar cell module 1 has a connection structure including both the plurality of solar cells 10 connected in series and the plurality of solar cells 10 connected in parallel.

In the solar cell module having the conventional configuration, if any solar cell is in the reverse bias condition due to shading or the like, there occurs mismatch in the current that flows through the solar cells, and the current value as the solar cell module is limited by the current value of the solar cell through which the lowest current flows, through the series connection circuit. As a result, the electric power cannot be efficiently extracted (i.e. the output decreases).

In contrast to the above, in the plurality of solar cells 10 in the matrix that constitutes the solar cell module 1 according to this embodiment, even when any solar cell is in the reverse bias condition due to shading or the like, the solar cell module 1 has both connection structures, i.e. the solar cells 10 connected in series and the solar cells 10 connected in parallel. Thus, although the solar cell 10 whose current value decreases serves as electrical resistance, the current flows through the parallel connection circuit avoiding this solar cell 10. Therefore, it is possible to overcome the conventional problem of decrease of the current value of one solar cell 10 limited by the lowered current value of the other solar cell 10.

Thus, it is possible to prevent reduction in the power generation amount of the solar cell module 1, which leads to the stable power generation amount. Also, it is possible to reduce generation of local heat that is called a hotspot phenomenon, which leads to reduction in the risk of damage of the solar cells. Here, the above effects can be more easily obtained when using split cells having a smaller area than that of the standard cells. Furthermore, as the area of the split cell becomes smaller, the greater effect can be obtained.

The solar cell 10 is not limited to the example shown in FIGS. 12 A and 12B. On the solar cell 10, it is sufficient that the respective locations of the end pads 132 on the light-receiving surface correspond to the respective locations of the end pads 132 on the back surface so that the wire-shaped (or linear) wiring members (the first wiring member 21, the second wiring member 22 and the like, described later) can be connected. Thus, the back surface electrode 12 on the back surface side is not necessarily required to be provided so as to be opposite to the front surface electrode 11 on the front surface side, and any other patterns can be adopted. Also, the solar cells 10 are not necessarily required to include the electrode corresponding to the busbar electrode. It is possible to adopt various configuration other than the above-described example.

FIG. 14 is a plan view illustrating a connection structure of solar cells 90 in a solar cell module as a comparative example. In FIG. 14, the solar cells 90 are viewed from the back surface side. Also, the illustration of a resin layer, a protection member and the like provided in the solar cell module is omitted here.

In the comparative example, a first wiring member 901 that extends in the first direction D1 on the back surfaces of the solar cells 90 connects one solar cell 90 to an adjacent solar cell 90 in the first direction D1. A second wiring member 902 that is connected to the first wiring members 901 is arranged along the second direction D2, in a clearance d between the solar cells 90 adjacent to each other in the first direction D1. Thus, although this configuration includes the parallel connection of the solar cells as in the case of the solar cell module 1 of this embodiment, there is a problem of a large clearance d between the solar cells 90 arranged in the first direction D1 in order to provide the second wiring member 902.

In contrast to the above, in the solar cell module 1 according to this embodiment, the second wiring members 22 are provided on the back surface side of the solar cells 10, and thus only the first wiring members 21 extend over the clearance between the solar cells 10. Thus, it is possible to reduce effectively the clearance between the solar cells 10 as the split cells so as to avoid increasing the entire size of the solar cell module 1. Also, since the first wiring member 21 (the second wiring member 22) is a wire-shaped conductive member, it can be easily bent, which leads to the connection of the front surface electrode 11 and the back surface electrode 12 with a reduced space.

Also, the second wiring members 22 that make the parallel connection are not necessarily required to be provided on the back surface of the solar cells 10. When the second wiring member 22 is the wire-shaped conductive member 201, the configuration shown in FIGS. 1 and 2 can also be applied to the light-receiving surface side of the solar cells 10.

In this case, the first wiring member 21 is connected to the front surface electrode 11 of one solar cell 10 and to the back surface electrode 12 of another solar cell 10 arranged adjacent to the one solar cell 10 in the first direction D1. Also, the conductive member 201 as the second wiring member 22 is connected to the first wiring member 21 that is connected to the front surface electrode 11. Thus, the parallel connection is established.

Alternatively, the conductive member 201 as the second wiring member 22 may be connected to the front surface electrode 11 of one solar cell 10 and to the front surface electrode 11 of another solar cell 10 arranged adjacent to the one solar cell 10 in the second direction D2. In this case, the first wiring member 21 is connected to the second wiring member 22 that is connected to the front surface electrode 11 of one solar cell 10 and to the back surface electrode 12 of another solar cell 10 arranged adjacent to the one solar cell 10 in the first direction D1. Thus, it is possible to configure the solar cell module 1 having a connection structure including both the plurality of solar cells 10 connected in series and the plurality of solar cells 10 connected in parallel.

### <Embodiment 2>

In the present disclosure, the connection structure including the parallel connection of a plurality of solar cells 10 of the solar cell module 1 is not limited to the structure described in Embodiment 1, but various other structures may be embodied. In the description of the solar cell module 1 according to Embodiments 2 to 5 below, the configuration that is common to Embodiment 1 is omitted to avoid duplication, and only the characteristic features are described.

FIG. 5 is a cross-sectional view schematically illustrating the configuration of the back surface of the solar cell 10 in the solar cell module 1 according to Embodiment 2, which is taken from line B-B of FIG. 2. From the solar cell 10 of FIG. 5 also, the components such as the resin layer 43, the protection member 42 of the back surface, and the front surface electrode 11 of the light-receiving surface are omitted. Only the configuration of the back surface of the solar cell 10 is shown in an enlarged manner.

In the solar cell module 1 according to this embodiment, the second wiring member 22 is the wire-shaped conductive member 201, and connects the back surface electrode 12 of one solar cell 10 and the back surface electrode 12 of another solar cell 10 arranged adjacent to the one solar cell 10 in the second direction D2. The second wiring member 22 is connected to the back surface electrode 12 of the solar cell 10 by welding or via a conductive adhesive.

Also, the first wiring member 21 connects the front surface electrode (11) of one solar cell 10 and the second wiring member 22 that is connected to the back surface electrode 12 of another solar cell 10 arranged adjacent to the one solar cell 10 in the first direction D1. The first wiring member 21 is connected to the second wiring member 22 by welding or via a conductive adhesive. The first wiring member 21 and the second wiring member 22 both may be wire-shaped conductive members (inter-connector wires).

The solar cell module 1 according to this embodiment also has both connection structures, i.e. the solar cells 10 connected in series and the solar cells 10 connected in parallel, and thus, even when any solar cell is in the reverse bias condition due to shading or the like, the current flows through the parallel connection circuit avoiding this solar cell 10. Therefore, it is possible to overcome the problem of decrease of the current value of any other solar cell 10 limited by the lowered current value. Also, it is possible to reduce generation of local heat that is called a hotspot phenomenon, which leads to reduction in the risk of damage of the solar cells.

### <Embodiment 3>

FIGS. 6 to 8 illustrate the solar cell module 1 according to Embodiment 3. FIG. 6 is an enlarged plan view illustrating a configuration of the back surface of the solar cell module 10. FIG. 7 is a cross-sectional view schematically illustrating the configuration of the back surface of the solar cell 10, which is taken from line B-B of FIG. 2. FIG. 8 is a cross-sectional view schematically illustrating another configuration of the back surface of the solar cell 10, which is taken from line B-B of FIG. 2. From these figures, the components of the solar cell 10 such as a resin layer 43, a protection member 42 of the back surface, and a front surface electrode 11 of the light-receiving surface are omitted. Only the configuration of the back surface of the solar cell 10 is shown in an enlarged manner.

In the solar cell module 1 according to Embodiments 1 and 2, the first wiring member 21 and the second wiring member 22 as the connection members 20 are both the wire-shaped conductive members (inter-connector wires) 201. However, the solar cell module 1 according to this embodiment is not limited thereto.

As exemplarily shown in FIG. 6, the second wiring member 22 provided on the back surface of the solar cell 10 so as to be connected to the first wiring member 21 may be a strip-shaped conductive member 202. More specifically, the conductive member 202 as the second wiring member 22 is a band-like wiring member (a busbar) made of an elongated ribbon-like (or strip-like) substrate whose outer surface is coated with a conductive adhesive or coated by soldering. The material for the substrate is not particularly limited and, for example, may be a metal such as copper.

As an example, the conductive member 202 is a strip-shaped wiring member whose size (width) in the width direction intersecting the lengthwise direction is about 5 mm. The material of the base member is not particularly limited, however, a metal such as copper may be used.

FIGS. 13 A and 13B show an example of the solar cell 10 of the solar cell module 1 in Embodiment 3. FIG. 13A is a plan view illustrating the light-receiving surface of the solar cell 10. FIG. 13B is a plan view illustrating the back surface of the solar cell 10.

As exemplarily shown in FIG. 13A, the solar cell 10 has a configuration in which the front surface electrode 11 is provided on the light-receiving surface of the solar cell 10. The solar cell 10 includes a busbar electrode and a finger electrode. The busbar electrode of the front surface electrode 11 is linearly provided on the light-receiving surface of the solar cell 10 in the first direction D1. The finger electrode is linearly formed from the busbar electrode in the second direction D2. In this case, the light-receiving surface side of the solar cell 10 is the same as that of the solar cell 10 shown in FIG. 12A.

As shown in FIG. 13B, the back surface electrode 12 is provided on the back surface side so as to be opposite to the front surface electrode 11 on the front surface side. The back electrode 12 is provided on the back surface of the solar cell 10 so as to linearly extend in the first direction D1. On the back surface electrode 12, conductive pads 13 each containing conductive particles such as silver paste are provided. The conductive pads 13 are located at a predetermined interval on the back surface electrode 12 extending in the first direction D1.

It is preferable that the second wiring member 22 is provided on the conductive pads 13 of the solar cell 10. As shown in FIG. 6, the second wiring member 22 extends in the second direction D2 so as to bridge the plurality of conductive pads 13 arranged in the second direction D2. Since the second wiring member 22 has a strip shape and thus has a certain width, it is suitably connected to the conductive pads 13 on the back surface electrode 12.

As shown in FIG. 7, the second wiring member 22 is provided on the back surface of the solar cell 10 (provided on the upper side in FIG. 7) so as to: intersect the first wiring member 21 that is connected to the back surface electrode 12; and be connected to the first wiring member 21. The second wiring member 22 is electrically connected to the first wiring member 21 by welding or via a conductive adhesive. In this way, the solar cells 10 of the solar cell module 1, which are arranged side by side in the second direction D2, are electrically connected in parallel by the second wiring member 22.

Also as shown in FIG. 8, the second wiring member 22 may be provided so as to connect the back surface electrodes 12 of the solar cell 10. In this case, the first wiring member 21 is provided along the first direction D1 so as to connect the second wiring members 22 that are connected to the back surface electrodes 12 of the solar cell 10. The second wiring member 22 is connected to the conductive pads on the back surface electrodes 12 on the back surface side of the solar cell 10 by welding or via a conductive adhesive. Also, the first wiring member 21 is connected to the second wiring member 22 by welding or via a conductive adhesive.

In this way, the solar cell module 1 has both connection structures, i.e. the solar cells 10 connected in series and the solar cells 10 connected in parallel. Since the second wiring member 22 is the strip-shaped conductive member 202, it is possible to further effectively collect the current, which leads to improvement of the power of the module.

Thus, in the solar cell module 1 according to this embodiment also, even when any solar cell is in the reverse bias condition due to shading or the like, the current flows through the parallel connection circuit avoiding this solar cell 10. Therefore, it is possible to overcome the problem of decrease of the current value of any other solar cell 10 limited by the lowered current value. Also, it is possible to reduce generation of local heat that is called a hotspot phenomenon, which leads to reduction in the risk of damage of the solar cells.

### <Embodiment 4>

FIG. 9 is a perspective view schematically illustrating a connection structure of the first wiring member 21 and the second wiring member 22 in the solar cell module 1 according to Embodiment 4.

In the above-described embodiments, the second wiring member 22 is the wire-shaped conductive member 201 or the strip-shaped conductive member 202. However, in the solar cell module 1 of the present disclosure, the second wiring member 22 is not limited thereto. As the second wiring member 22, a foil-like conductive member (metal foil 203) may be used.

As shown in FIG. 9, the metal foil 203 as the second wiring member 22 is provided on the back surface of the solar cell 10 so as to connect the respective back surface electrodes (not shown) of one solar cell 10 and another solar cell 10 arranged adjacent to each other in the second direction D2. Furthermore, the first wiring member 21 connects the front surface electrode (not shown) of one solar cell 10 and the metal foil 203 as the second wiring member 22 that is connected to the back surface electrode of another solar cell 10 arranged adjacent to the one solar cell 10 in the first direction D1.

The second wiring member 22 is, for example, the metal foil 203 such as a copper foil. The width of the second wiring member 22 in the first direction D1 is substantially the same as that of the solar cell 10 in the first direction D1. The length of the second wiring member 22 in the second direction D2 is to sufficiently extend and bridge the plurality of solar cells 10 arranged in the second direction D2.

In this case, the metal foil 203 as the second wiring member 22 is connected to the back surface electrode (12) of the solar cell 10 by welding or via a conductive adhesive. Also, the first wiring member 21 is connected to the second wiring member 22 by welding or via a conductive adhesive.

The solar cell module 1 configured as described above can also have both connection structures, i.e. the solar cells 10 connected in series and the solar cells 10 connected in parallel, in the same way as the above-described embodiments. Also in this solar cell module 1, it is possible to reduce generation of the hotspot phenomenon, which stabilizes the power generation amount.

### <Embodiment 5>

FIGS. 10 and 11 are perspective views each schematically illustrating a connection structure of the connection members in the solar cell module 1 according to Embodiment 5.

In the above-described embodiments, the second wiring member 22 is the conductive member having the shape of the wire, the strip or the foil. However, the solar cell module 1 in the present disclosure is not limited thereto. For example, as shown in FIG. 10, the first wiring member and the second wiring member constituting the connection members 20 may intersect each other so as to make a mesh-shaped conductive member 200.

As exemplarily shown in FIG. 11, a wiring member such as a smart wire formed in a sheet shape may be used as the mesh-shaped conductive member 200, which can reduce power loss due to electrical resistance in the surface direction of the solar cell 10 for power transport. In this case, the conductive member 200 made of the sheet-shaped smart wire is provided on the light-receiving surface side of the solar cells 10 arranged adjacent to each other in the second direction D2, and also is provided on the back surface side of the solar cells 10 arranged adjacent to each other in the first direction D1. In this way, it is possible to connect, by the conductive member 200, both the solar cells 10 arranged adjacent to each other in the first direction D1 and the solar cells 10 arranged adjacent to each other in the second direction D2. Thus, the solar cell module 1 can have the connection structure of the solar cells 10 in the matrix, i.e. both the solar cells 10 connected in series and the solar cells 10 connected in parallel. Also, it is possible to reduce generation of the hotspot phenomenon, which stabilizes the power generation amount.

As described above, in the solar cell module 1 of the present disclosure, even when shading or the like of the solar cell 10 occurs, it is possible to prevent reduction in the power generation amount of the solar cell module 1 and to stabilize the power generation amount. Also, it is possible to prevent generation of the hotspot phenomenon, which leads to reduction in the risk of damage of the solar cells.

The solar cell module 1 according to the embodiments of the present disclosure is not limited to the above-described configurations, but it can have various other configurations. For example, the solar cell module 1 can be suitably applied to a solar cell module having a curved surface shape. In this case, at least part of the resin layer 43 of the solar cell module 1 has a curved surface shape in the entire solar cell module 1. The transparent substrate 41 and the protection member 42 are disposed along the curved surface shape of the resin layer 43. Furthermore, since the solar cells 10 are sealed by the resin layer 43, they are also disposed along the curved surface shape of the resin layer 43.

The solar cell 10 provided in the solar cell module 1 may be a single-sided light receiving type or may be a double-sided light receiving type. The kind of the solar cell 10 is not particularly limited, and various semiconductor materials such as a polycrystalline semiconductor and a thin film semiconductor may be applied to the solar cell 10. The number of the first wiring members 21 and the number of the second wiring members 22, both serving as the connection members 20, are not particularly limited. It is sufficient that two or more first wiring members 21 and two or more second wiring members 22 are used with respect to one solar cell 10.

The aforementioned embodiments and examples are for only illustrative purposes in every respect and provide no basis for restrictive interpretations. The technical scope of the present disclosure is defined only by the claims and never bound by the embodiments and examples. Any modifications and variations that may lead to equivalents of claimed elements are all included within the scope of the disclosure.

This application claims priority based on Patent Application No. 2022-116671 filed in Japan on July 21, 2022. The entire contents thereof are hereby incorporated in this application by reference.

### Description of the Reference Numerals

- 1: Solar cell module
- 10: Solar cell
- 11: Front surface electrode
- 12: Back surface electrode
- 13: Conductive pad
- 20: Connection member
- 21: First wiring member
- 22: Second wiring member
- 200: Mesh-shaped conductive member
- 201: Wire-shaped conductive member
- 202: Strip-shaped conductive member
- 203: Metal foil
- 31: Busbar
- 41: Transparent substrate
- 42: Protection member
- 43: Resin layer
- D1: First direction
- D2: Second direction

## Claims

1. A solar cell module comprising:
a plurality of solar cells arranged in a first direction and in a second direction orthogonal to the first direction; and
connection members electrically connecting the plurality of solar cells, wherein
the connection members include: a first wiring member that connects, in the plurality of solar cells, one solar cell and another solar cell arranged adjacent to each other in the first direction; and a second wiring member that connects, in the plurality of solar cells, one solar cell and another solar cell arranged adjacent to each other in the second direction,
the second wiring member is provided on a light-receiving surface side of the solar cells or a back surface side opposite to the light-receiving surface side so as to intersect the first wiring member and also to be electrically connected to the first wiring member, and
the plurality of solar cells is connected in series by the first wiring member and is connected in parallel by the second wiring member.

2. The solar cell module according to claim 1, wherein
the first wiring member is connected to a front surface electrode of the one solar cell and to a back surface electrode of the other solar cell arranged adjacent to the one solar cell in the first direction, and
the second wiring member is connected to the first wiring member that is connected to the back surface electrode.

3. The solar cell module according to claim 1, wherein
the second wiring member is connected to a back surface electrode of the one solar cell and to a back surface electrode of the other solar cell arranged adjacent to the one solar cell in the second direction, and
the first wiring member is connected to a front surface electrode of the one solar cell and to the second wiring member that is connected to a back surface electrode of the other solar cell arranged adjacent to the one solar cell in the first direction.

4. The solar cell module according to claim 1, wherein
the first wiring member is connected to a front surface electrode of the one solar cell and to a back surface electrode of the other solar cell arranged adjacent to the one solar cell in the first direction, and
the second wiring member is connected to the first wiring member that is connected to the front surface electrode.

5. The solar cell module according to claim 1, wherein
the second wiring member is connected to a front surface electrode of the one solar cell and to a front surface electrode of the other solar cell arranged adjacent to the one solar cell in the second direction, and
the first wiring member is connected to the second wiring member that is connected to a front surface electrode of the one solar cell and to a back surface electrode of the other solar cell arranged adjacent to the one solar cell in the first direction.

6. The solar cell module according to claim 3, wherein
the second wiring member is a metal foil.

7. The solar cell module according to claim 2 or 3, wherein
the second wiring member is a strip-shaped conductive member.

8. The solar cell module according to any one of claims 1 to 5, wherein
the second wiring member is a wire-shaped conductive member.

9. The solar cell module according to claim 1, wherein
the first wiring member and the second wiring member constitute a mesh-shaped conductive member by being intersected with and connected to each other.
